# EUROPEAN PATENT APPLICATION

(11) **EP 4 772 278 A1**
(43) Date of publication of application: **08.07.2026**
(21) Application number: 24859963.1
(22) Date of filing: 30.08.2024
(51) Int. Cl.: B01J 35/39, B01J 23/10, B01J 37/02, B01J 37/34, C23C 14/08, C23C 14/34

(54) **PHOTOCATALYST MEMBER AND METHOD FOR PRODUCING PHOTOCATALYST MEMBER**

(30) Priority: 01.09.2023 JP 2023142559
(71) Applicant: Dexerials Corporation, Shimotsuke-shi, Tochigi 323-0194 (JP)
(72) Inventor: WAKO, Hitoshi, Shimotsuke-shi, Tochigi 323-0194 (JP)
(74) Representative: Lavoix
(86) International application number: PCT/JP2024/031225
(87) International publication number: WO 2025/047938

(57) **Abstract**

This photocatalyst member is a photocatalyst member containing, in the following order, a base material, an underlying layer, and a photocatalyst layer formed in contact with the underlying layer, in which the underlying layer is a composite oxide of cerium and zinc, and the photocatalyst layer contains titanium oxide.

## Description

### TECHNICAL FIELD

The present invention relates to a photocatalyst member and a method for producing a photocatalyst member.

Priority is claimed on Japanese Patent Application No. 2023-142559, filed September 1, 2023, and 2024-148221, filed August 30, 2024, the contents of which are incorporated herein by reference.

### BACKGROUND ART

A photocatalyst, which exhibits a catalytic action by light such as ultraviolet rays and visible rays, is currently attracting attention since it has various effects. Strong oxidizability due to the generation of hydrogen/oxygen by photolysis of water or generation of reactive oxygen on the surface, superhydrophilicity due to the generation of a large number of hydroxyl groups on the surface, and the like are known as the effects obtained by a photocatalysist, which are particularly evident in the Honda-Fujishima effect. The photocatalyst has been considered for application to various applications such as an anti-fogging film that utilizes superhydrophilicity, where, in particular, the photocatalyst sterilizes, by light irradiation, viruses and pathogens such as coronaviruses, which have become remarkably prevalent in recent years, or decomposes formaldehyde, which causes sick house syndrome.

In addition, in a case where the photocatalyst is applied to an antireflection film, it is expected to be effective in decomposing finger marks that have adhered to the surface of the antireflection film. Particularly, since an antireflection film obtained from a dielectric multilayer film in which inorganic substances having different refractive indexes and having a thickness of 1 µm or less are alternately laminated uses light interference, the interference effect is disrupted, and transparent foreign matter is likely to be easily visible even in a case where transparent foreign matter such as slight finger marks adheres to the surface. In the related art, the antireflection film was covered with a substance having low surface energy, such as a fluorine compound, to suppress adhesion of transparent foreign matter such as fingerprint marks; however, the effect thereof was not sufficient, and cleaning such as wiping was necessary. In a case where transparent foreign matter, which is an organic substance, can be decomposed by a photocatalyst to solve such problems, such a photocatalyst is highly promising because cleaning is unnecessary.

As a material having photocatalytic performance, titanium oxide is known. As a method for forming titanium oxide on the surface of some kind of base material, a vacuum thin film forming method such as sputtering is known. However, in order for titanium oxide to exhibit photocatalytic performance, crystallization such as anatase type or rutile type is required, and for crystallization, a heat treatment of 300°C or more during film formation or after film formation is required. For this reason, it is difficult to apply a photocatalyst to a member such as a plastic member having low heat resistance. As another method, a method for applying a crystallized titanium oxide fine powder onto a base material together with a binding agent and immobilizing the crystallized titanium oxide fine powder is proposed. This coating method is very widely used because it does not require treatment such as heating and it makes it possible to carry out a large area treatment, and most of the photocatalysts currently commercialized are based on this coating method.

### Citation List

### Patent Document

Patent Document 1: Japanese Unexamined Patent Application, First Publication No. 2007-308729
Patent Document 2: Japanese Unexamined Patent Application, First Publication No. 2007-314835
Patent Document 3: Japanese Patent No. 5217023
Patent Document 4: Japanese Unexamined Patent Application, First Publication No. 2000-345320
Patent Document 5: Japanese Patent No. 4460537

### SUMMARY OF THE INVENTION

### Technical Problem

However, the binding agent to be used for immobilization on the base material is often an organic substance, and there is a problem in that the decomposition of the binding agent, referred to as the choking phenomenon, occurs due to contact with the photocatalyst, and the photocatalyst itself falls off. In addition, there is also a problem in that in a case where the ratio of the binding agent is increased in order to strengthen the binding between the base material and the photocatalyst, the ratio of the photocatalyst is relatively reduced, and the catalyst performance is lowered.

Therefore, it is desirable to form a titanium oxide thin film by a vacuum thin film forming method in which a binding agent is not used; however, an object to be achieved is how photocatalytic performance can be realized by forming a film at room temperature.

As a method for obtaining titanium oxide that has been crystallized at room temperature, Patent Document 1 discloses a method for setting a duty ratio of voltage application to a constant value or less by using a single cathode or a dual cathode. Patent Document 1 describes that titanium oxide crystallized by this method can be obtained; however, in a case where the inventors of the present invention carried out a reproduction experiment, crystallization could not be confirmed, and thus the crystallization may depend on the configuration of facilities, and the like.

In addition, Patent Document 2 and Patent Document 3 disclose a method for promoting crystallization by dividedly carrying out film formation of a titanium metal film and an oxidation treatment thereof into two parts. However, complicated configurations are required in terms of facilities, which makes it difficult to achieve the realization thereof with a general-purpose sputtering device.

As an example that uses a general-purpose sputtering device, a method for carrying out crystallization by adding moisture during film formation and carrying out a heat treatment at a relatively low temperature (200°C or higher) as described in Patent Document 4 has been attempted. However, even though it is a low-temperature crystallization, heating above 200°C is required, and thus a lot of plastic base materials are deformed. For this reason, there is a problem of a lack of versatility.

As a method for obtaining photocatalytic performance by room temperature film formation using a general-purpose sputtering device, there is a method for forming a film by using zirconium oxide (zirconia) as an underlying layer and then forming a film of titanium oxide as described in Patent Document 5. This method can be said to be an excellent method that is capable of realizing photocatalytic performance without carrying out a heat treatment on titanium oxide.

However, due to the low degree of crystallization of zirconium oxide, a certain degree of film thickness was required to function as a sufficient underlying layer, and thus productivity was low.

Further, since zirconium oxide itself has insulating properties, it is necessary to use a method such as high frequency (RF) sputtering to form a film by sputtering, and productivity is remarkably low due to the slow film forming speed thereof and the difficulty in film formation on a large area scale. As another method for obtaining photocatalytic performance without a high temperature environment, a method for forming zirconium oxide by subjecting metal zirconium to direct current reactive sputtering under an inert gas environment and a reactive gas environment is also considered. However, it is extremely difficult to realize stable production since sputtering conditions greatly vary depending on the oxidation state of the surface of zirconium oxide as a target.

The present invention has been made to solve such problems, and the object of the present invention is to provide a photocatalyst having high industrial productivity by searching for an underlying layer different from zirconium oxide.

### Solution to Problem

To such problems, the inventors of the present invention carried out a diligent study and have arrived at the present invention. The inventors of the present invention have found that titanium oxide of a photocatalyst member obtained by allowing a target to have conductivity by using a composite oxide target obtained by mixing and sintering cerium oxide (CeO₂) and zinc oxide (ZnO), forming a film as an underlying layer with sputtering by using the target, and then forming a film of titanium oxide exhibits photocatalytic performance without a heat treatment.

Further, the inventors of the present invention have found that direct current sputtering can be carried out by using a target formed by mixing cerium oxide (CeO₂) and zinc oxide (ZnO) in a range of 3:1 to 3:2 in amount of substance ratio (molar ratio), and a photocatalyst member exhibiting particularly a favorable photocatalytic performance can be prepared by forming a titanium oxide layer without heating after forming the underlying layer by using the target.

Although it is desirable that the underlying layer is a composite oxide of cerium and zinc, the underlying layer may contain other elements. For example, a gallium (Ga) element, an aluminum (Al) element, and the like, may be contained to enhance the conductivity of zinc oxide. In addition, the conductivity is only necessary for carrying out direct current (DC) sputtering, and the underlying layer may have no conductivity. It is known that a photocatalyst layer to be obtained even in a case where the underlying layer has a thickness of 10 nm has an effect of exhibiting photocatalytic performance; however, in a case of a plastic film or the like, the thickness of the underlying layer is preferably 20 nm or more from the viewpoint of ensuring surface smoothness. Sufficient crystallinity can be maintained in a case where it is 20 nm or more; however, formation of a film of 100 nm or more not only places a thermal load on the base material but also is industrially inefficient, and thus it is desirable to set the thickness to 100 nm or less.

The photocatalyst layer in the photocatalyst member according to the present invention has titanium oxide (TiO₂) as a main component; however, it may contain other elements in a case where photocatalytic performance is exhibited. For example, titanium oxide has a band gap in the ultraviolet region and requires ultraviolet rays to act as a photocatalyst; however, there is an example in which nitrogen has been added to make it responsive to visible light. Even in the present invention, nitrogen can be added to form a photocatalyst responsive to visible light. In addition, a metal element, for example, niobium, may be added to enhance the electrical conductivity of the photocatalyst layer. In addition, in the present invention, titanium oxide may not exhibit crystallinity. It is sufficient that the thickness of the photocatalyst layer is equal to or larger than a thickness at which the photocatalytic performance is exhibited, and for example, it is sufficient that the thickness thereof is 40 nm or more. Even in a case where the thickness of the photocatalyst layer is large, the effect of the present invention is exhibited; however, industrially, it is desirable to be 200 nm or less.

Further, a layer other than the underlying layer and the photocatalyst layer may be provided on the base material. For example, a film of silicon oxide may be formed on the surface of the photocatalyst layer for the intended purpose of retaining the superhydrophilicity of the photocatalyst. In addition, a conductive layer may be formed on the base material before forming the underlying layer in order to use the present invention as a photocatalytic electrode, which is evident in the Honda-Fujishima effect.

In any case, the present invention is completed by forming a film of titanium oxide on a surface opposite to the base material among the surfaces of the underlying layer made of a composite oxide of cerium oxide and zinc oxide.

That is, the present invention provides the following means.
(1) A photocatalyst member according to one aspect of the present invention is a photocatalyst member including, in the following order, a base material, an underlying layer, and a photocatalyst layer formed in contact with the underlying layer, in which the underlying layer is a composite oxide of cerium and zinc, and the photocatalyst layer contains titanium oxide.
(2) In the photocatalyst member according to (1) above, amount of substance ratio between cerium oxide and zinc oxide, which are contained in the underlying layer, may be in a range of 3:1 to 1:1.
(3) In the photocatalyst member according to (1) or (2) above, an element ratio of elements other than the titanium oxide contained in the photocatalyst layer may be 10% or less.
(4) In the photocatalyst member according to any one of (1) to (3) above, a thickness of the underlying layer may be 10 nm or more.
(5) In the photocatalyst member according to (1) to (4) above, a thickness of the photocatalyst layer may be 40 nm or more.
(6) The photocatalyst member according to (1) to (5) above may further include a hydrophilicity retaining layer on the photocatalyst layer, in which the hydrophilicity retaining layer may contain silicon oxide or a composite oxide of silicon and another metal.
(7) In the photocatalyst member according to (1) to (6) above, the base material may be a transparent base material.
(8) In the photocatalyst member according to (1) to (7) above, the base material may be a polymer film.
(9) In the photocatalyst member according to (1) to (8) above, the underlying layer may further contain a group III element, and a total amount of the group III element contained in the underlying layer may be 10% or less in amount of substance ratio.
(10) A method for producing a photocatalyst member according to one aspect of the present invention includes an underlying layer forming step of forming an underlying layer on a base material, and a photocatalyst layer forming step of forming a photocatalyst layer containing titanium oxide, on the underlying layer, in which in the underlying layer forming step, the base material is subjected to sputtering by using a composite target mixed with cerium oxide and zinc oxide.
(11) In the method for producing a photocatalyst member according to (10) above, a mixing ratio between cerium oxide and zinc oxide in the composite target may be in a range of 3:1 to 3:2 in terms of amount of substance ratio.
(12) In the method for producing a photocatalyst member according to (10) or (11) above, the composite target may have conductivity.
(13) In the method for producing a photocatalyst member according to (10) to (12) above, sputtering with direct current discharge or sputtering with alternating current discharge may be carried out in the underlying layer forming step.
(14) In the method for producing a photocatalyst member according to (10) to (13) above, the photocatalyst layer is formed in the photocatalyst layer forming step by sputtering using a target containing any one consisting of titanium, a titanium alloy, or oxygen-deficient titanium oxide.
(15) In the method for producing a photocatalyst member according to (10) to (14) above, the base material may be a polymer film.

### Advantageous Effects of Invention

According to the present invention, it is possible to provide a photocatalyst having high industrial productivity. For example, it is possible to use a photocatalyst member exhibiting photocatalytic performance without going through a heat treatment at a high temperature and a base material having low heat resistance, it is possible to increase a film forming speed, and it is possible to provide a method for producing a photocatalyst member, which makes it possible to produce a photocatalyst member exhibiting photocatalytic performance.

### BRIEF DESCRIPTION OF DRAWINGS

[FIG. 1] A cross-sectional view showing an example of a configuration of a photocatalyst member according to one embodiment of the present invention.
[FIG. 2] A cross-sectional view showing a configuration of a photocatalyst member according to a modified example of FIG. 1.
[FIG. 3] A graph showing an XRD spectrum of an underlying layer formed on an alkali-free glass base material in Example 1.

### DESCRIPTION OF EMBODIMENTS

The drawings that are used in the following description may show characteristic portions in an enlarged scale for convenience in order to facilitate the understanding of the characteristics of the present invention, and thus the dimensional ratios or the like of the respective constitutional elements may differ from the actual ones. The materials, dimensions, and the like, which are exemplified in the following description, are merely examples, and the present invention is not limited thereto. Therefore, an appropriate modification can be made within the scope that the effects thereof are exhibited. In addition, the upper limit value and/or lower limit value of the numerical value range described in the present specification can be combined in any desired manner to define a preferred range. For example, an upper limit value and a lower limit value of a numerical value range can be combined in any desired manner to define a preferred range.

### [Photocatalyst member]

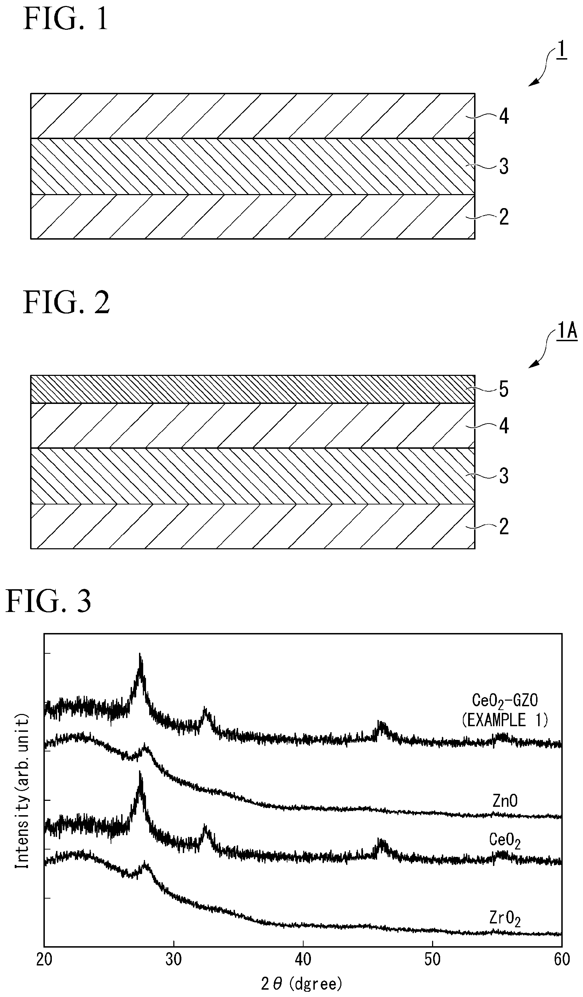

FIG. 1 is a cross-sectional view showing an example of a configuration of a photocatalyst member according to one embodiment of the present invention. A photocatalyst member 1 shown in Fig. 1 includes, in the following order, a base material 2, an underlying layer 3, and a photocatalyst layer 4 formed in contact with the underlying layer 3, in which the underlying layer 3 consists of a composite oxide of cerium and zinc, and the photocatalyst layer 4 contains titanium oxide. In the present embodiment, the number of layers of the underlying layer 3 and the number of layers of the photocatalyst layer 4 are each typically one layer, and in the example shown in FIG. 1, the photocatalyst layer 4 is the outermost layer of a laminate.

### <Base material>

The base material 2 may be composed of any material. Examples of the material of the base material 2 include glass, metal, resin, ceramics, and the like. Examples of the resin to be usable for the base material 2 include a resin film such as a polymer film. In particular, a resin film in which the thickness of the resin is small has many advantages such that the resin film is lightweight and can be affixed in various places. Further, for industrial reasons, there is such an advantage that a continuous film formation treatment can be carried out in mass production by using a roll-to-roll sputtering device. Further, a transparent resin (polymer) film can also be used in a case of being used in a place such as a windowpane or a display where light needs to be transmitted.

The material of the transparent resin film is not specifically limited, and for example, polyethylene terephthalate (PET), polyethylene naphthalate (PEN), polyaramide, polyimide, polycarbonate, polyethylene, polypropylene, triacetyl cellulose (TAC), polycycloolefin (COC or COP), or the like can be used.

The base material 2 is preferably a transparent base material. The transparent base material may be formed from a transparent material capable of transmitting light in the visible light range. For example, the transmittance of the transparent base material with respect to the light in the visible light range is 80% or more.

The thickness of the base material 2 is not particularly limited. However, in a case where the base material 2 is a resin film, it is desirable to set the thickness of the base material 2 to 20 µm or more and 200 µm or less in consideration of ease of handling during manufacturing and thinning of the member. It is noted that, from the viewpoint of improving the scratch resistance of the base material 2, it is also possible to form, for example, a coating film obtained from an acrylic resin, on at least one surface of the base material 2 by applying, for example, a solution. In addition, a base material in which organic or inorganic particles are dispersed inside the acrylic resin for the intended purpose of improving the degree of hazing and film travelability may be used.

### <Underlying layer>

The underlying layer 3 is a composite oxide of cerium and zinc. The contents of cerium and zinc in the underlying layer 3 are, for example, within a range of cerium (Ce):zinc (Zn) = 9:1 to 1:1 in terms of amount of substance ratio. In other words, the contents of cerium and zinc in the underlying layer 3 are, for example, within a range of Ce:Zn = 9:1 to 1:1 in terms of amount of substance ratio. As for the contents of cerium and zinc in the underlying layer 3, Ce:Zn is preferably in a range of 3:1 to 13:12 in terms of amount of substance ratio, may be in a range of 3:1 to 1:1, may be in a range of 7:3 to 3:2, and may be in a range of 2:1 to 3:2 or 62:38 to 52:48. The photocatalyst layer 4 formed directly above the underlying layer 3 exhibits particularly a favorable photocatalytic performance in a case where the amount of substance ratio between cerium and zinc in the underlying layer 3 is within the range.

The underlying layer 3 is preferably composed of a composite oxide containing only cerium and zinc as a metal element. That is, it is preferable that the underlying layer 3 has a content of 0% of the third element which will be described later. On the other hand, the underlying layer 3 may contain one or a plurality of kinds of other elements in addition to cerium, zinc, and oxygen. In the present embodiment, a metal element other than cerium and zinc, which are contained in the underlying layer 3, is referred to as the third element. The third element is, for example, a gallium (Ga) element, an aluminum (Al) element, or an indium (In) element, which is added to enhance the conductivity of zinc oxide. As described above, the third element is, for example, a group III element. The content of the third element other than cerium, zinc, and oxygen in the underlying layer 3 is preferably 10% or less. The composition of the underlying layer 3 corresponds to the composition of the composite target that is used in the manufacturing process described later. The element contained in the underlying layer 3 can be measured by, for example, an X-ray microanalyzer (XMA) or an X-ray photoelectron spectroscopy (electron spectroscopy for chemical analysis: ESCA). By the measurement, it is also possible to measure the amount of substance ratio of the contents of cerium and zinc. In the underlying layer 3, the total amount of the third elements as elements other than cerium and zinc is, for example, 10% or less, preferably 5% or less, and more preferably 2% or less in terms of an atomic ratio (amount of substance ratio). In addition, the total amount of the third elements may be 0; however, it may be 0.5% or more or 1% or more.

A resistance value of the target for forming the underlying layer 3 is preferably 100 Ω·cm or less and more preferably 1 Ω·cm or less in a case where DC sputtering is carried out in the manufacturing process. In the present embodiment, in a case where direct current (DC) sputtering is carried out in the manufacturing process, it is necessary for the target material to have conductivity; however, the underlying layer 3 formed by sputtering the target material may not have conductivity.

The thickness of the underlying layer 3 is, for example, 8 nm or more and preferably 10 nm or more, and since the surface may not be smooth in a case where the base material 2 is a plastic film or the like, the thickness thereof is more preferably 20 nm or more from the viewpoint of ensuring a sufficient amount of composite oxide in any position in the in-plane direction. In addition, in a case where the thickness of the underlying layer 3 is 20 nm or more, it can be said that sufficient crystallinity can be maintained. From the viewpoint that a thermal load on the base material 2 is suppressed in the manufacturing process and the viewpoint that the improvement in crystallinity for the photocatalyst layer 4 to exhibit sufficient catalytic performance is saturated in a case where the underlying layer 3 is sufficiently thick, the thickness of the underlying layer 3 is preferably 100 nm or less, and the thickness of the underlying layer 3 may be 50 nm or less. The thickness of the underlying layer 3 can be obtained by preparing a cross-sectional slice of a sample according to a microtome method and carrying out measurement with a transmission electron microscope.

### <Photocatalyst layer>

The photocatalyst layer 4 is a layer that functions as a photocatalyst. The photocatalyst layer 4 contains titanium oxide as a photocatalyst. More specifically, the photocatalyst layer 4 is composed of only titanium oxide or composed of at least one or more other kinds of elements, the ratio of which is 10 atom% or less in total in terms of an element ratio of titanium oxide and titanium. Titanium oxide has a band gap in the ultraviolet region and generally requires ultraviolet rays to act as a photocatalyst; however, titanium oxide can be made responsive to visible light by adding nitrogen. In the present invention, in the photocatalyst layer 4, nitrogen may be added to titanium oxide to form a photocatalyst responsive to visible light. Even in this case, the content of nitrogen in the photocatalyst layer 4 is 10 atom% or more with respect to titanium oxide and the titanium element. In addition, a metal element, for example, niobium (Nb), may be contained to enhance the electrical conductivity of the photocatalyst layer.

However, this configuration is merely an example, and titanium oxide may be contained in the photocatalyst layer 4 to the extent that the effect of the present embodiment can be obtained. The element contained in the photocatalyst layer 4 can be measured by, for example, an X-ray microanalyzer (XMA) or fluorescence X-ray analysis (X-ray fluorescence: XRF).

It is desirable that the thickness of the photocatalyst layer 4 is at least 40 nm or more in order to make the photocatalyst layer 4 function as a photocatalyst. The photocatalyst layer 4 may have any thickness as long as it is thick; however, the thickness thereof is desirable to be 200 nm or less from the viewpoint that titanium oxide also has a slow film forming speed, and in terms of industrial productivity. The thickness of the photocatalyst layer 4 can be obtained by preparing a cross-sectional slice of a sample according to a microtome method and carrying out measurement with a transmission electron microscope.

In addition, further improvement in decomposition performance was not observed even in a case where the thickness of titanium oxide was made larger than 200 nm in the photolysis performance evaluation.

The photocatalyst member according to the present embodiment is not limited to a photocatalyst member composed of the base material 2, the underlying layer 3, and the photocatalyst layer 4, as illustrated in FIG. 1, and it may have another layer between the base material 2 and the underlying layer 3, or on the photocatalyst layer 4.

For example, one or more layers of conductive materials may be laminated between the base material 2 and the underlying layer 3 for the intended purpose of allowing the photocatalyst member 1 to have conductivity. Examples of such a conductive material include an indium-tin composite oxide (ITO) and an aluminum-zinc composite oxide (AZO). In addition, a metal material may be laminated. Further, a different oxide may be laminated to suppress oxidation due to plasma which is used in a case where the underlying layer 3 is formed on the metal material. Further, an intimate attachment layer may be formed for the intended purpose of ensuring the adherence between the base material 2 and the underlying layer 3. Further, in a case where the base material 2 is a transparent base material, a transparent material may be formed into a film for the intended purpose of enhancing the transparency of the photocatalyst member 1. Further, a smooth layer may be formed to smooth the surface of the base material 2.

In addition, a transparent material may be formed on the surface of the photocatalyst layer 4. In particular, a hydrophilicity retaining layer containing silicon oxide or a composite oxide of silicon oxide and another metal may be formed on the photocatalyst layer 4 so that superhydrophilicity can be maintained for a long time in a dark place. FIG. 2 is a cross-sectional view showing a configuration of such a photocatalyst member according to a modified example of FIG. 1. A photocatalyst member 1A illustrated in FIG. 2 further has a hydrophilicity retaining layer 5 on the photocatalyst layer 4 of the photocatalyst member 1 illustrated in FIG. 1. In a case where the hydrophilicity retaining layer 5 contains a composite oxide, the metal contained is, for example, Na or Al.

In addition, since titanium oxide used for the photocatalyst layer is a material having a high refractive index, a layer of a material having a low refractive index, such as silicon oxide, may be laminated on the photocatalyst layer for the intended purpose of reducing the refractive index of the surface. For example, at a position where the hydrophilicity retaining layer 5 in FIG. 2 is provided, a low refractive material layer may be formed instead of the hydrophilicity retaining layer 5. In addition, a low refractive material layer may be formed between the photocatalyst layer 4 and the hydrophilicity retaining layer 5.

### [Method for producing photocatalyst member]

The photocatalyst members 1 and 1A shown in FIG. 1 and FIG. 2 can be produced, for example, by the following method. A method for producing the photocatalyst members 1 and 1A according to one embodiment of the present invention includes an underlying layer forming step of forming an underlying layer 3 on a base material 2, and a photocatalyst layer forming step of forming a photocatalyst layer 4 containing titanium oxide, on the underlying layer 3, in which in the underlying layer forming step, the base material 2 is subjected to sputtering by using a composite target mixed with cerium oxide and zinc oxide. In a case of producing a photocatalyst member by a roll-to-roll method, the base material 2 tha has been wound around an unwinding roll is first unwound.

### (Underlying layer forming step)

Next, the underlying layer 3 is formed on the base material 2 which has been unwound and appropriately subjected to a predetermined treatment. Any method may be used for the manufacturing method for the underlying layer 3. However, the sputtering method is effective in terms of lamination of different materials for forming a multilayer film. In the sputtering method, there are various methods such as high frequency (RF) sputtering, alternating current discharge (AC) sputtering, direct current discharge (DC) sputtering, and the like; however, in the high-speed/large-area film formation and the long-length film formation using a continuous winding device, alternating current (AC) sputtering or direct current (DC) sputtering is mainly used. In a case where high frequency (RF) sputtering is used, there is little restriction on the target material, and various substances can be sputtered; however, as described above, it is not suitable for the high speed/large-area and long-length film formation. In alternating current (AC) sputtering or direct current (DC) sputtering, the target material to be used needs to have conductivity; however, alternating current (AC) sputtering or direct current (DC) sputtering is suitable for the high speed/large-area and long-length film formation. In the underlying layer forming step, for example, an inside of a chamber in which a base material and a composite target are accommodated is allowed to be in an oxygen and inert gas atmosphere, and the underlying layer forming step is carried out in a decompression environment.

It is preferable to carry out the underlying layer forming step by DC sputtering or AC sputtering among the above methods from the viewpoint of preparing a photocatalyst member that exhibits photocatalytic performance without going through a heat treatment at a high temperature. In a case of forming an underlying layer by DC sputtering or AC sputtering, a composite target having conductivity is used. In the present embodiment, having conductivity means, for example, that the resistance is 100 Ω·cm or less. The resistance of the composite target is preferably 100 Ω·cm or less.

The composite target to be used in the underlying layer forming step is a mixture of cerium oxide and zinc oxide. The composition of the underlying layer 3 formed in the underlying layer forming step depends on the composition in the composite target. Therefore, an underlying layer having any composition can be manufactured by examining the correlation between the amount of substance ratio of contents of cerium and zinc in the composite target and the amount of substance ratio of contents of cerium and zinc in the underlying layer 3. In other words, in order to form an underlying layer having amount of substance ratio between the above-described cerium oxide and zinc oxide within a predetermined range, the contents of cerium and zinc in the composite target are, for example, within a range of cerium (Ce):zinc (Zn) = 9:1 to 1:1 in terms of amount of substance ratio, and it is preferably in a range of 3:1 to 3:2 and more preferably in a range of 18:7 to 13:7, and may be in a range of 7:3 to 13:7 from the viewpoint of film formation by DC sputtering. In a case of forming an underlying layer 3 containing a third element other than cerium, zinc, and oxygen, the composite target also contains a corresponding third element. That is, the composite target may contain the same third element as the underlying layer 3. For example, the composite target can contain, as the third element, the gallium element, the aluminum element, the indium element, or the like, which is added to enhance the conductivity of zinc oxide. In a case where the target material does not contain the third element, the composition of the underlying layer 3 to be formed is approximately the same as that of the target material. As for the resistance of the target, the third element contributes as a dopant of zinc oxide, the resistance value decreases, and the film formation rate of the composite target increases faster; however, it is presumed that the composition deviation occurs because the rate increase of zinc oxide is larger than the rate increase of cerium oxide.

In the underlying layer forming step, sputtering can be carried out under a condition in which, for example, the pressure (reachable vacuum degree) is 10⁻² Pa. In addition, for example, a sputtering power of 50 to 300 W can be used.

The composite target that is used in the underlying layer forming step can be prepared, for example, by weighing and mixing the raw material powder and carrying out sintering, a powder molding method, and the like. In a case of preparing the composite target by mixing the raw material powder and then carrying out sintering, the heating temperature can be set to, for example, 1,000°C to 1,400°C, and the heating time can be set to, for example, 2 to 6 hours. In a case of preparing the composite target by the powder molding method, the composite target can be molded by accommodating the raw material powder in the die and pressurizing it with an upper punch and a lower punch.

### (Photocatalyst layer forming step)

Next, the photocatalyst layer 4 is formed on the underlying layer 3. The manufacturing method for the photocatalyst layer 4 may be any method. However, the sputtering method is effective in terms of lamination of different materials for forming a multilayer film.

In a case of forming the photocatalyst layer 4 on the underlying layer 3 by sputtering, it is possible to use, as the target, any composite oxide containing, for example, titanium, a titanium alloy, an oxygen-deficient titanium oxide, and an oxygen-deficient titanium oxide. As the titanium alloy, a titanium alloy containing niobium, copper, tungsten, and the like, in addition to the titanium element, can be used. The oxygen-deficient titanium oxide is a titanium oxide represented by the general formula TiOx, where x in the formula is a value less than 2.

In the photocatalyst layer forming step, for example, an inside of a chamber in which the base material 2 having a surface on which the underlying layer 3 is formed and the target are accommodated is filled with oxygen and argon gas, and sputtering is carried out under a decompression environment.

According to the method for producing a photocatalyst member and the photocatalyst member according to the embodiments described above, a photocatalyst having high industrial productivity can be realized by using a composite oxide of cerium and zinc for the underlying layer 3. It is possible to exhibit the function as a photocatalyst, for example, even in a case where the photocatalyst layer 4 is not heated after the formation of the photocatalyst layer 4.

Cerium oxide and zirconium oxide are insulators. Therefore, it is possible to form a film using a high frequency (RF) sputtering method, whereas it is not possible to form a film using a general direct current (DC) sputtering method. Although high frequency sputtering is an excellent method in terms of the fact that even a film of an insulator can be formed, the film forming speed is remarkably slow as compared with that of the direct current (DC) sputtering method. In addition, since the same frequency band as the radio wave is used, leakage in a case where a film is formed with large power may cause serious radio wave interference in the surrounding area, which is not suitable for the high speed/large-area production, which is important for industrial application. Particularly in a case where a roll-to-roll film forming method for continuously forming an underlying layer and a photocatalyst layer on a film is used, the use of the vapor deposition method or the like may be considered; however, it is considered to be desirable that both the underlying layer and the photocatalyst layer are formed by a sputtering method.

In the above embodiment, the composite target of cerium oxide and zinc oxide, which is used in forming the composite oxide of cerium and zinc in the underlying layer, exhibits conductivity, which is not exhibited by cerium oxide. Therefore, the underlying layer can be formed by DC sputtering without carrying out RF sputtering.

Therefore, according to the above embodiment, it is possible to use a photocatalyst member exhibiting photocatalytic performance without going through a heat treatment at a high temperature and a base material having low heat resistance, it is possible to increase a film forming speed, and it is possible to provide a method for producing a photocatalyst member, which makes it possible to produce a photocatalyst member exhibiting photocatalytic performance. In addition, since sputtering conditions are not significantly changed depending on the surface oxidation state of the target, it is easy to realize stable production.

In addition, it is considered that, in the photocatalyst members 1 and 1A according to the above embodiment, a crystal lattice is formed by the underlying layer 3, and titanium oxide undergoes crystal growth to match the crystallite, thereby exhibiting a favorable photocatalytic performance.

In addition, due to the fact that in the formation of the underlying layer 3, it is difficult to uniformly form a film, particularly, on a thin film of about 100 nm or less on the film by the sol-gel method, it is considered that it is difficult to form a photocatalyst layer 4 that exhibits a favorable photocatalytic performance without heating.

### [Examples]

Hereinafter, the present invention will be specifically described with reference to examples and comparative examples; however, the present invention is not limited to the examples below.

### [Example 1]

First, as a preparation step, a powder of cerium oxide (CeO₂) and a powder of gallium-added zinc oxide (GZO) were weighed and mixed in a ratio of 7:3 in terms of amount of substance ratio and then heated at 1,400°C for 4 hours to prepare a sintered target (composite target) for an underlying layer. In addition, the resistivity of the prepared composite target was measured by LORESTA GP MCP-T610 (Nittoseiko Analytech Co., Ltd.).

Next, an alkali-free glass (OA-10G, manufactured by Nippon Electric Glass Co., Ltd.) was prepared as a base material. After washing with water using a neutral detergent, the base material was subjected to ultrasonic cleaning in pure water for 10 minutes, and after pulling the base material out of the liquid, the liquid droplets were immediately removed with an air gun and dried. The base material was set in a four-source sputtering device (manufactured by Toei Scientific Industrial Col., Ltd., model number: SPV-420), and film formation was carried out after exhausting. Using a switching switch, both DC discharge and RF discharge can be used for the sputtering device. In Example 1, the underlying layer forming step was carried out by DC discharge.

Detailed conditions for the underlying layer forming step are shown below.

### (Sputtering conditions)

· Target Dimensions: 2 inches in diameter, 4 mm in thickness
· Distance between target and base material: 80 mm
· Reachable vacuum degree: < 1 × 10⁻³ Pa
· Base material temperature: room temperature
· Sputtering power: DC 100 W

As described above, the underlying layer was formed to have a thickness of 50 nm by DC sputtering.

Further, titanium oxide (TiO₂) as a photocatalyst layer was laminated to 150 nm under the following film formation conditions and then taken out to prepare a sample. In the formation of the photocatalyst layer, oxygen-deficient titanium oxide TiOx was used as the target.

### (Sputtering conditions)

· Target Dimensions: 2 inches in diameter, 4 mm in thickness
· Distance between target and base material: 80 mm
· Reachable vacuum degree: < 1 × 10⁻³ Pa
· Base material temperature: room temperature
· Sputtering power: RF 200 W

### [Example 2]

A sample was prepared under the same conditions as in Example 1, except that when preparing the composite target used in the underlying layer forming step, a powder of cerium oxide (CeO₂) and a powder of gallium-added zinc oxide (GZO) were mixed in a ratio of 3:1 in amount of substance ratio.

### [Example 3]

A sample was prepared under the same conditions as in Example 1, except that when preparing the composite target used in the underlying layer forming step, a powder of cerium oxide (CeO₂) and a powder of gallium-added zinc oxide (GZO) were mixed in a ratio of 3:2 in amount of substance ratio.

### [Example 4]

A sample was prepared under the same conditions as in Example 1, except that the thickness of the film of the underlying layer was set to 10 nm.

### [Example 5]

A sample was prepared under the same conditions as in Example 1, except that the thickness of the film of the photocatalyst layer was set to 40 nm.

### [Example 6]

A sample was prepared under the same conditions as in Example 1, except that when preparing the composite target used in the underlying layer forming step, a powder of cerium oxide (CeO₂) and a powder of zinc oxide (ZnO) were mixed in a ratio of 7:3 in amount of substance ratio.

### [Example 7]

A sample was prepared under the same conditions as in Example 1, except that when preparing the composite target used in the underlying layer forming step, a powder of cerium oxide (CeO₂) and a powder of aluminum-added zinc oxide (AZO) were mixed in a ratio of 7:3 in amount of substance ratio.

### (Sputtering conditions)

· Target Dimensions: 2 inches in diameter, 4 mm in thickness
· Distance between target and base material: 80 mm
· Reachable vacuum degree: < 1 × 10⁻³ Pa
· Base material temperature: room temperature
· Sputtering power: RF 200 W

### [Comparative Example 1]

A sample was prepared by laminating titanium oxide to 150 nm as a photocatalyst layer without forming an underlying layer. That is, in Comparative Example 1, TiO₂ was directly formed as a photocatalyst layer on the alkali-free glass base material. The formation of the layer composed of TiO₂ was carried out by sputtering using the same target as that of Example 1.

### [Comparative Example 2]

A sample was prepared under the same conditions as in Example 1, except that oxygen-deficient niobium pentoxide (NbOx) was used as a target for an underlying layer.

### [Reference Example 1]

A powder of cerium oxide (CeO₂) and a powder of gallium-added zinc oxide (GZO) were mixed as a composite target in a ratio of 4:1 in amount of substance ratio, and then sintering was carried out under the same conditions as in Example 1 to prepare a target for an underlying layer. By using the composite target, DC sputtering was attempted on the alkali-free glass base material under the same conditions as in Example 1, and as a result, it was not possible to carry out discharge with the DC sputtering device, and it was not possible to prepare a sample in which an underlying layer was formed on a base material.

### [Evaluation]

Photocatalytic performance was evaluated for the prepared sample. The evaluation of photocatalytic performance was carried out in accordance with JIS R 1703-1 (Fine ceramics - Test method for self-cleaning performance of photocatalytic materials - Part 1: Measurement of water contact angle).

Specifically, the sample was placed in a position where the radiation illuminance was adjusted to 2.0 mW/cm² under the black light and allowed to stand for more than 24 hours. Thereafter, oleic acid was applied thinly and uniformly so that the amount thereof was 2.0 mg per 100 cm². A contact angle at this point in time was defined as the initial contact angle.

After measuring the initial contact angle, the sample was allowed to stand for 24 hours at a position where the radiation illuminance was set to be 2.0 mW/cm² under the black light and taken out to measure again the contact angle, thereby determining the contact angle after UV irradiation.

According to the photocatalytic performance determination standard according to the Photocatalysis Industry Association of Japan, it can be said that a favorable photocatalytic performance is obtained in a case where the contact angle is 30° or less after UV irradiation.

In addition, for each sample, the thickness of the underlying layer immediately after the underlying layer forming step was evaluated using spectral ellipsometry (M-2000, manufactured by J.A. Woollam Co., Inc.). An amplitude ratio Ψ and a phase difference Δ of p polarization and s polarization are obtained for each wavelength in the ellipsometry; however, by applying an appropriate optical model to these and carrying out fitting including the film thickness as a parameter, the film thickness is obtained together with the optical constant. Based on the measurement result at the central part of the base material, the film thickness was determined.

The evaluation results concerning the sample preparation conditions, the resistivity of the composite target for preparing the underlying layer, and the photocatalytic performance are summarized in Table 1. In Table 1, the description of "OK" in the column of "Discharge" of the underlying layer indicates that the discharge can be carried out by using a DC sputtering device under the same sputtering conditions as in Example 1, and the description of "NG" indicates that the discharge was not possible. "Infinite" in the column of the target resistance indicates that the resistance was above the measurement limit.

**[Table 1]**

| | Underlying layer | | | | | Photocatalyst layer | | Contact angle | |
|---|---|---|---|---|---|---|---|---|---|
| | Target material (amount of substance ratio) | Target resistance [Ω/□] | Discharge | Underlying layer composition (amount of substance ratio) | Thickness | Material | Thickness [nm] | Immediately after application of oleic acid [°] | After 24 hours [°] |
| Example 1 | CeO₂:GZO (7:3) | 8.00 × 10⁻² | OK | CeO₂:ZnO (62:38) | 50 | TiO₂ | 150 | 60 | 15 |
| Example 2 | CeO₂:GZO (3:1) | 1.70 × 10⁻¹ | OK | CeO₂:ZnO (67:33) | 50 | TiO₂ | 150 | 61 | 12 |
| Example 3 | CeO₂:GZO (3:2) | 2.40 × 10⁻² | OK | CeO₂:ZnO (52:48) | 50 | TiO₂ | 150 | 62 | 17 |
| Example 4 | CeO₂:GZO (7:3) | 8.00 × 10 ² | OK | CeO₂:ZnO (62:38) | 10 | TiO₂ | 150 | 60 | 18 |
| Example 5 | CeO₂:GZO (7:3) | 8.00 × 10⁻² | OK | CeO₂:ZnO (62:38) | 50 | TiO₂ | 40 | 59 | 19 |
| Example 6 | CeO₂:ZnO (7:3) | 1.00 × 10⁻¹ | OK | CeO₂:ZnO (70:30) | 50 | TiO₂ | 150 | 60 | 17 |
| Example 7 | CeO₂:AZO (7:3) | 8.30 × 10⁻² | OK | CeO₂:ZnO (65:35) | 50 | TiO₂ | 150 | 61 | 18 |
| Comparative Example 1 | -- | -- | -- | | -- | TiO₂ | 150 | 61 | 62 |
| Comparative Example 2 | NbOx | 9.40 × 10³ | OK | Nb₂O₅ (100) | 50 | TiO₂ | 150 | 64 | 63 |
| Reference Example 1 | CeO₂:GZO (4:1) | Infinite | NG | | -- | -- | -- | -- | -- |

### [Results of evaluation]

### <Examples 1 to 3>

As clearly revealed from Table 1, discharge is possible in a case where the amount of substance ratio between CeO₂ and GZO was in a range of 3:1 to 3:2. In addition, in a case where the prepared sample is irradiated with UV light for 24 hours after applying oleic acid, the contact angle is 30° or less, and a sufficient self-cleaning performance is exhibited. Therefore, it can be said that a favorable photocatalytic performance is obtained.

### <Example 4>

Even in a case where the underlying layer is formed to have a thickness of 10 nm as compared with the case of Example 1, the contact angle is 30° or less, and a sufficient self-cleaning performance is exhibited in a case where irradiation is carried out with UV light for 24 hours after applying oleic acid. Therefore, it can be said that a favorable photocatalytic performance is obtained.

### <Example 5>

Even in a case where a film is formed in order for the titanium oxide of the photocatalyst layer to have a thickness of 40 nm as compared with the case of Example 1, the contact angle is 30° or less, and a sufficient self-cleaning performance is exhibited in a case where irradiation is carried out with UV light for 24 hours after applying oleic acid. Therefore, it can be said that a favorable photocatalytic performance is obtained.

### <Example 6>

Discharge was possible even in a case where, as compared with the case of Example 1, a composite target for an underlying layer was prepared by using zinc oxide (ZnO) instead of GZO. In addition, in a case where the prepared sample is irradiated with UV light for 24 hours after applying oleic acid onto the prepared sample, the contact angle is 30° or less, and a sufficient self-cleaning performance is exhibited. Therefore, it can be said that a favorable photocatalytic performance is obtained.

### <Example 7>

Discharge was possible even in a case where, as compared with the case of Example 1, a composite target for an underlying layer was prepared by using aluminum-added zinc oxide (AZO) instead of GZO. In addition, in a case where the prepared sample is irradiated with UV light for 24 hours after applying oleic acid onto the prepared sample, the contact angle is 30° or less, and a sufficient self-cleaning performance is exhibited. Therefore, it can be said that a favorable photocatalytic performance is obtained.

### <Comparative Examples 1 and 2>

In a case where titanium oxide was formed directly on the base material without forming an underlying layer (Comparative Example 1), or in a case where a metal oxide other than the composite oxide of cerium and zinc was formed as the underlying layer, and then titanium oxide was formed on the metal oxide (Comparative Example 2), the contact angle after carrying out irradiation with UV light for 24 hours after applying oleic acid was not 30° or less, and it was confirmed that the self-cleaning performance is not exhibited, photocatalytic performance is not obtained. As described above, a layer of titanium oxide formed without interposing the underlying layer, or a layer formed directly on the underlying layer 3 which is formed as a layer other than the composite oxide of cerium and zinc, has no photocatalytic performance.

### [Composition of underlying layer]

In order to investigate the composition of the underlying layer, an underlying layer was formed using each target under the same conditions as in examples, reference examples, and comparative examples, and then the underlying layer was taken out without forming a photocatalyst layer to evaluate the element ratio between Ce and Zn by X-ray photoelectric spectroscopy (ESA). The results are shown in Table 1.

### [Evaluation of crystallinity]

In Example 1, a sample immediately after the formation of the underlying layer was evaluated by XRD. For XRD, the measurement was carried out using X'Pert PRO MPD (manufactured by PANalytical) with Cuα as a radiation source and at an incident angle of 1°. The XRD results are shown in FIG. 3. FIG. 3 also shows the XRD of zinc oxide, cerium oxide, and zirconium oxide for comparison.

As the XRD spectra of zinc oxide, cerium oxide, and zirconium oxide, XRD spectra for a film thickness of 50 nm formed by RF sputtering on the same alkali-free glass base material as in Example 1 are shown.

As shown in FIG. 3, the peak of cerium oxide can be confirmed at a position close to the peak position of zirconium oxide, and the fact that the half width thereof is narrow suggests that crystallites larger than the crystallites of zirconium oxide are present. This suggests that cerium oxide is more likely to crystallize. In contrast, the thin film formed of a composite target of cerium oxide and gallium-added zinc oxide shows XRD similar to that of cerium oxide, and the crystallite size is also presumed to be about the same as that of cerium oxide. The XRD of zinc oxide is also shown in the graph; however, it is considered that the crystal confirmed by the cerium oxide and gallium-added zinc oxide from the comparison of peak positions is a crystallite of cerium oxide.

Partial heteroepitaxial growth is considered to be the reason why the titanium oxide formed on the underlying layer exhibits photocatalytic performance in a case of forming the underlying layer that is composed of the composite oxide of cerium and zinc. It is considered that a crystal lattice is formed by the underlying layer, and the crystal of titanium oxide grows to match the crystallite thereof. Therefore, in a case where the underlying layer side is crystallized clearly to have a thin film thickness, titanium oxide of the photocatalyst layer to be formed thereafter is also considered to promote crystallization.

### REFERENCE SIGNS LIST

1,1A Photocatalyst member
2 Base material
3 Underlying layer
4 Photocatalyst layer
5 Hydrophilicity retaining layer

## Claims

1. A photocatalyst member comprising, in the following order:
a base material;
an underlying layer; and
a photocatalyst layer formed in contact with the underlying layer,
wherein the underlying layer is a composite oxide of cerium and zinc, and
the photocatalyst layer contains titanium oxide.

2. The photocatalyst member according to Claim 1,
wherein amount of substance ratio between cerium oxide and zinc oxide, which are contained in the underlying layer, is in a range of 3:1 to 1:1.

3. The photocatalyst member according to Claim 1,
wherein an element ratio of elements other than the titanium oxide contained in the photocatalyst layer is 10% or less.

4. The photocatalyst member according to Claim 1,
wherein a thickness of the underlying layer is 10 nm or more.

5. The photocatalyst member according to Claim 1,
wherein a thickness of the photocatalyst layer is 40 nm or more.

6. The photocatalyst member according to Claim 1, further comprising:
a hydrophilicity retaining layer on the photocatalyst layer,
wherein the hydrophilicity retaining layer contains silicon oxide or a composite oxide of silicon and another metal.

7. The photocatalyst member according to Claim 1,
wherein the base material is a transparent base material.

8. The photocatalyst member according to Claim 1,
wherein the base material is a polymer film.

9. The photocatalyst member according to Claim 1,
wherein the underlying layer further contains a group III element, and
a total amount of the group III element contained in the underlying layer is 10% or less in amount of substance ratio.

10. A method for producing a photocatalyst member, comprising:
an underlying layer forming step of forming an underlying layer on a base material; and
a photocatalyst layer forming step of forming a photocatalyst layer containing titanium oxide, on the underlying layer,
wherein in the underlying layer forming step, the base material is subjected to sputtering by using a composite target mixed with cerium oxide and zinc oxide.

11. The method for producing a photocatalyst member according to Claim 10,
wherein a mixing ratio between cerium oxide and zinc oxide in the composite target is in a range of 3:1 to 3:2 in amount of substance ratio.

12. The method for producing a photocatalyst member according to Claim 10,
wherein the composite target has conductivity.

13. The method for producing a photocatalyst member according to Claim 10,
wherein sputtering with direct current discharge or sputtering with alternating current discharge is carried out in the underlying layer forming step.

14. The method for producing a photocatalyst member according to Claim 10,
wherein the photocatalyst layer is formed in the photocatalyst layer forming step by sputtering using a target containing any one consisting of titanium, a titanium alloy, or oxygen-deficient titanium oxide.

15. The method for producing a photocatalyst member according to Claim 10,
wherein the base material is a polymer film.
